# EUROPEAN PATENT APPLICATION

(11) **EP 4 060 727 A1**
(43) Date of publication of application: **21.09.2022**
(21) Application number: 21196541.3
(22) Date of filing: 14.09.2021
(51) Int. Cl.: H01L 23/49, H01L 25/07

(54) **SEMICONDUCTOR DEVICE**

(30) Priority: 17.03.2021 JP 2021043742
(71) Applicant: KABUSHIKI KAISHA TOSHIBA, Minato-ku Tokyo 105-0023 (JP)
(72) Inventor: Uchida, Masayuki, Tokyo, 105-0023 (JP); Yamamoto, Tetsuya, Tokyo, 105-0023 (JP); Takahashi, Toshihide, Tokyo, 105-0023 (JP); Sato, Katsuya, Tokyo, 105-0023 (JP)
(74) Representative: Hoffmann Eitle

(57) **Abstract**

A semiconductor device includes: a first chip (130A) including a first electrode (133); a wiring member (123); a second chip (130B) located between the first chip (130A) and the wiring member (123) and including a second electrode (133); a first conductive plate (140A) located on the first electrode (133), in a second direction a dimension of the first conductive plate (140A) being greater than a dimension of the first chip (130A), the second direction being orthogonal to a first direction, said first direction being directed from the first chip toward the second chip; a second conductive plate (140B) located on the second electrode (133), in a second direction a dimension of the second conductive plate (140B) being greater than a dimension of the second chip (130B); and a first wire (152) being bonded to the wiring member (123), a portion of the first conductive plate (140A) protruding further in the second direction than the first chip (130A), and a portion of the second conductive plate (140B) protruding further in the second direction than the second chip (130B).

## Description

### FIELD

Embodiments relate to a semiconductor device.

### BACKGROUND

A conventional semiconductor device is known in which multiple chips are electrically connected by bonding wires.

### BRIEF DESCRIPTION OF THE DRAWINGS

FIG. 1 is a top view showing a semiconductor device according to an embodiment;
FIG. 2 is an enlarged top view of a region surrounded with broken line A of FIG. 1;
FIG. 3 is a cross-sectional view along line B-B' of FIG. 2;
FIG. 4 is an enlarged top view of the region surrounded with broken line A of FIG. 1 in which the conductive plates and the wires of FIG. 1 are not illustrated;
FIG. 5 is an enlarged top view of the region surrounded with broken line A of FIG. 1 in which the wires of FIG. 1 are not illustrated; and
FIG. 6 is an enlarged top view of a portion of a semiconductor device of a reference example.

### DETAILED DESCRIPTION

In general, according to one embodiment, a semiconductor device, includes: a first chip including a first electrode; a wiring member separated from the first chip; a second chip located between the first chip and the wiring member, the second chip including a second electrode; a first conductive plate located on the first electrode and electrically connected to the first electrode, a maximum dimension in a second direction of the first conductive plate being greater than a maximum dimension in the second direction of the first chip, the second direction crossing a first direction, the first direction being from the first chip toward the second chip; a second conductive plate located on the second electrode and electrically connected to the second electrode, a maximum dimension in the second direction of the second conductive plate being greater than a maximum dimension in the second direction of the second chip; and a first wire, the first wire being bonded to the wiring member, a portion of the first conductive plate protruding further in the second direction than the first chip, and a portion of the second conductive plate protruding further in the second direction than the second chip.

Various embodiments will be described hereinafter with reference to the accompanying drawings.

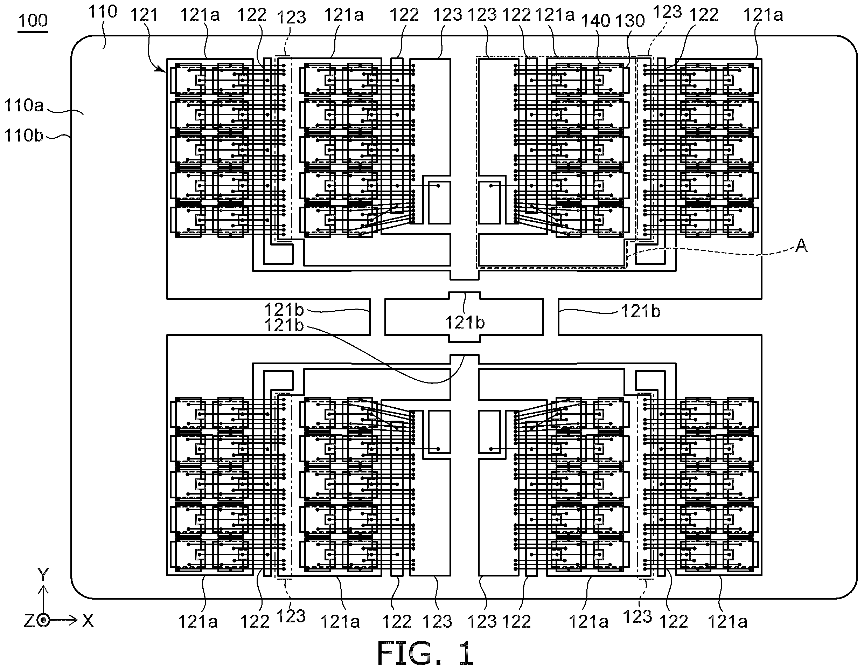

FIG. 1 is a top view showing a semiconductor device according to an embodiment.

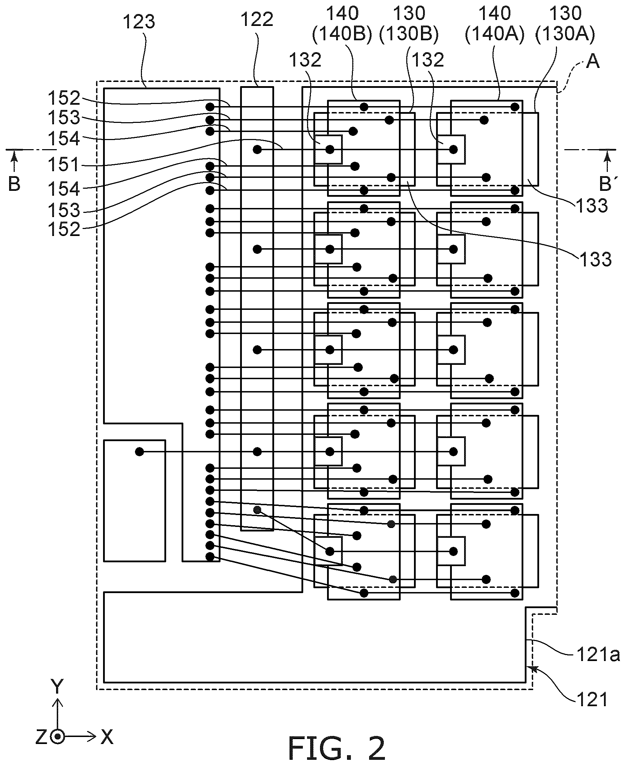

FIG. 2 is an enlarged top view of a region surrounded with broken line A of FIG. 1.

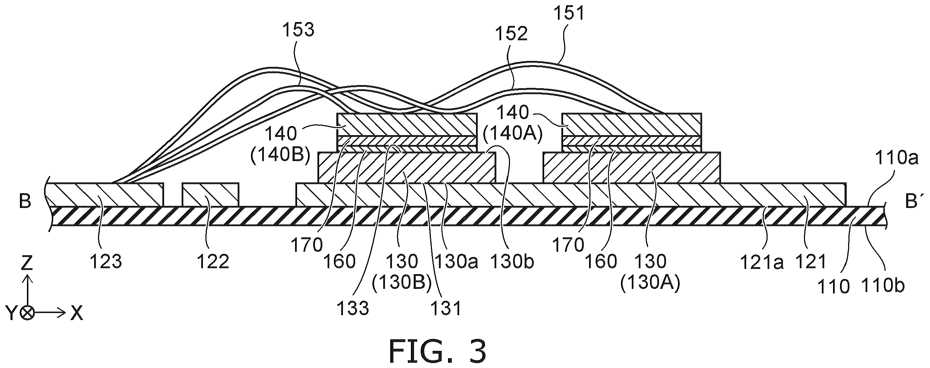

FIG. 3 is a cross-sectional view along line B-B' of FIG. 2.

The semiconductor device 100 according to the embodiment is a power semiconductor device. For example, the semiconductor device 100 is mounted in a vehicle such as an automobile, a train, etc., and is used in the switching control of a motor mounted in the vehicle. It is desirable for such a semiconductor device 100 to output a large current. However, the application objects of the semiconductor device are not particularly limited to those described above.

As shown in FIG. 1, the semiconductor device 100 includes a substrate 110, a drain connection leadframe 121 that is located on the substrate 110, multiple gate connection leadframes 122 that are located on the substrate 110, and multiple source connection leadframes 123 (wiring members) that are located on the substrate 110. As shown in FIGS. 2 and 3, the semiconductor device 100 further includes multiple chips 130 that are located on the drain connection leadframe 121, multiple conductive plates 140 that are located respectively on the multiple chips 130, and multiple wires 151, 152, 153, and 154.

The components of the semiconductor device 100 will now be elaborated. An XYZ orthogonal coordinate system is used for easier understanding of the following description. The direction from the substrate 110 toward the chip 130 is taken as a "Z-direction". Although the Z-direction is taken as the "upward direction" and the opposite direction of the Z-direction is taken as the "downward direction", these directions are independent of the direction of gravity. A direction orthogonal to the Z-direction is taken as an "X-direction". A direction orthogonal to the Z-direction and the X-direction is taken as a "Y-direction".

For example, the substrate 110 is made of an insulating material. The substrate 110 is flat-plate shaped. When viewed in top-view, the substrate 110 has a rectangular shape of which the X-direction is the longitudinal direction and the corners are rounded. However, the shape of the substrate 110 is not limited to that described above. As shown in FIG. 3, the surfaces of the substrate 110 include an upper surface 110a and a lower surface 110b that are substantially parallel to the X-direction and the Y-direction.

The drain connection leadframe 121, the gate connection leadframe 122, and the source connection leadframe 123 are located at the upper surface 110a of the substrate 110. A heat dissipation member such as a metal plate, etc., may be located under the substrate 110.

The leadframes 121, 122, and 123 are made of a metal material such as copper (Cu), etc. The leadframes 121, 122, and 123 are flat-plate shaped.

As shown in FIG. 1, the drain connection leadframe 121 includes multiple support portions 121a and multiple connection portions 121b.

According to the embodiment, ten chips 130 are located on each support portion 121a. The ten chips 130 on each support portion 121a are located in a matrix of two columns in the X-direction and five rows in the Y-direction. However, the number of chips located on each support portion is not limited to the number described above as long as the number is not less than 2. Also, the arrangement of the chips on each support portion is not limited to that described above.

According to the embodiment, the number of the support portions 121a included in the semiconductor device 100 is 8. The eight support portions 121a are arranged to have two support portions 121a next to each other in the Y-direction and four support portions 121a arranged in the X-direction.

According to the embodiment, the number of the connection portions 121b included in the semiconductor device 100 is 4. One of the four connection portions 121b connects the support portion 121a positioned furthest at the -X side and furthest at the +Y side and the support portion 121a positioned furthest at the +X side and furthest at the +Y side. Another one of the four connection portions 121b connects the support portion 121a positioned furthest at the -X side and furthest at the -Y side and the support portion 121a positioned furthest at the +X side and furthest at the -Y side. Another one of the four connection portions 121b connects the support portion 121a positioned furthest at the -X side and furthest at the +Y side and the support portion 121a positioned furthest at the -X side and furthest at the -Y side. Another one of the four connection portions 121b connects the support portion 121a positioned furthest at the +X side and furthest at the +Y side and the support portion 121a positioned furthest at the +X side and furthest at the -Y side. However, the number and location of the support portions are not limited to those described above.

According to the embodiment, the semiconductor device 100 includes eight gate connection leadframes 122 that correspond to the eight support portions 121a of the drain connection leadframe 121. Each gate connection leadframe 122 is located next to the corresponding support portion 121a in the X-direction. Specifically, each gate connection leadframe 122 is located inward of the corresponding support portion 121a in the X-direction. Each gate connection leadframe 122 extends in the Y-direction. However, the shapes and positions of the gate connection leadframes are not limited to those described above.

Similarly, according to the embodiment, the semiconductor device 100 includes eight source connection leadframes 123 that correspond to the eight support portions 121a of the drain connection leadframes 121. Each source connection leadframe 123 is located so that the gate connection leadframe 122 is sandwiched between the source connection leadframe 123 and the corresponding support portion 121a. Specifically, each source connection leadframe 123 is located inward of the corresponding drain connection leadframe 121 and the corresponding gate connection leadframe 122 in the X-direction.

The source connection leadframe 123 that is positioned furthest at the -X side and furthest at the +Y side is linked to the support portion 121a positioned at the +X side of the source connection leadframe 123. The source connection leadframe 123 that is positioned furthest at the +X side and furthest at the +Y side is linked to the support portion 121a positioned at the - X side of the source connection leadframe 123. The source connection leadframe 123 that is positioned furthest at the -X side and furthest at the -Y side is linked to the support portion 121a positioned at the +X side of the source connection leadframe 123. The source connection leadframe 123 positioned furthest at the +X side and furthest at the -Y side is linked to the support portion 121a positioned at the -X side of the source connection leadframe 123. The other source connection leadframes 123 extend in the Y-direction and are not linked to the support portions 121a. However, the shapes and positions of the source connection leadframes are not limited to those described above.

The gate connection leadframe 122 is separated from the drain connection leadframe 121 and the source connection leadframe 123.

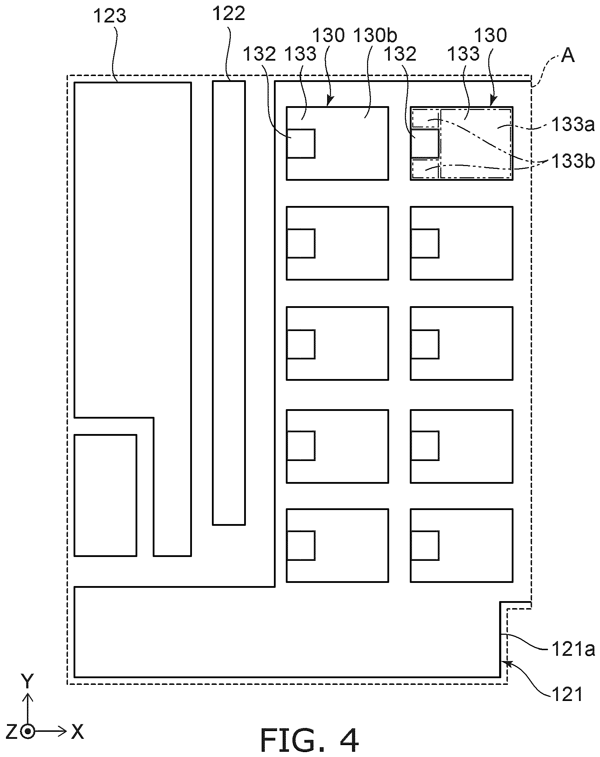

FIG. 4 is an enlarged top view of the region surrounded with broken line A of FIG. 1 in which the conductive plates and the wires of FIG. 1 are not illustrated.

According to the embodiment, the chips 130 are MOSFETs (metal-oxide-semiconductor field-effect transistors). The chips 130 are substantially flat-plate shaped. When viewed in top-view, the chips 130 are rectangular. However, the shapes of the chips are not limited to those described above.

As shown in FIG. 3, the surface of each chip 130 includes a lower surface 130a that faces the drain connection leadframe 121, and an upper surface 130b that is positioned at the side opposite to the lower surface 130a. A drain electrode 131 is located at the lower surface 130a. The drain electrode 131 is electrically connected to the drain connection leadframe 121. As shown in FIG. 4, a gate electrode 132 and a source electrode 133 are located at the upper surface 130b.

According to the embodiment, the drain electrode 131, the gate electrode 132, and the source electrode 133 each include aluminum (Al) as a major material. The drain electrode, the gate electrode 132, and the source electrode 133 each are made of aluminum (Al) having a purity that is not less than 95% and not more than 100%. However, the materials included in the drain electrode, the gate electrode, and the source electrode are not limited to those described above as long as a conductive material such as a metal or the like is used.

When viewed in top-view, the gate electrode 132 is substantially rectangular. The gate electrode 132 is located at the X-direction end portion of the upper surface 130b at the Y-direction central portion. However, the shape and position of the gate electrode are not limited to those described above.

When viewed in top-view, the source electrode 133 includes a substantially rectangular first region 133a, and a pair of second regions 133b that is separated from each other in the Y-direction and protrudes in the X-direction from the first region 133a. The gate electrode 132 is located between the pair of second regions 133b. The gate electrode 132 and the source electrode 133 are electrically insulated from each other in each chip 130.

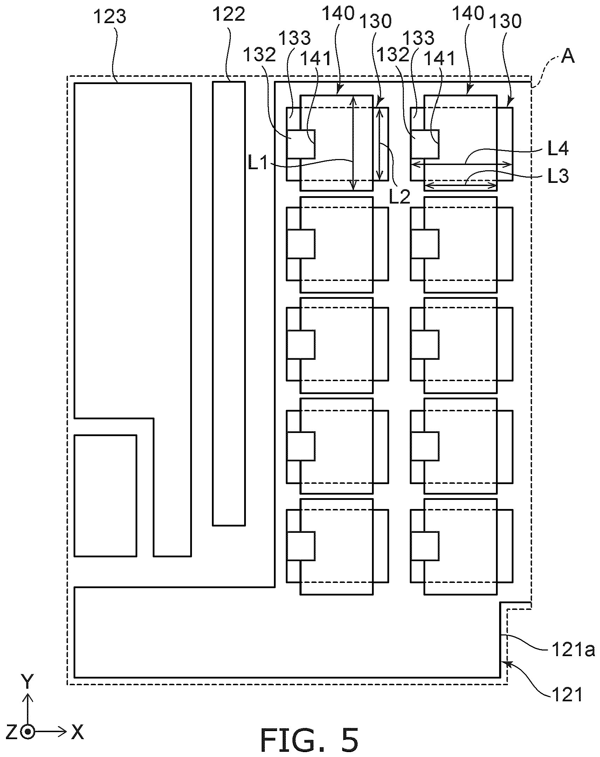

FIG. 5 is an enlarged top view of the region surrounded with broken line A of FIG. 1 in which the wires of FIG. 1 are not illustrated.

The conductive plate 140 is located on the source electrode 133 of each chip 130. For example, the conductive plate 140 is made of a metal material such as copper (Cu), etc. The conductive plate 140 is substantially flat-plate shaped.

The conductive plate 140 does not cover the gate electrode 132 and is electrically insulated from the gate electrode 132. Specifically, a recess 141 that is concave in the X-direction is formed in the side surface of the conductive plate 140 so that the gate electrode 132 is exposed. However, the shape of the conductive plate is not limited to that described above. For example, when viewed in top-view, the conductive plate may be rectangular, and the conductive plate may be separated from the gate electrode in the X-direction.

A maximum dimension L1 in the Y-direction of the conductive plate 140 is greater than a maximum dimension L2 in the Y-direction of the chip 130. Therefore, the two Y-direction end portions of the conductive plate 140 protrude from the chip 130. However, one Y-direction end portion of the conductive plate may protrude from the chip; and the other Y-direction end portion may not protrude from the chip. A maximum dimension L3 in the X-direction of the conductive plate 140 is less than a maximum dimension L4 in the X-direction of the chip 130. However, the size relationship between the maximum dimension in the X-direction of the conductive plate and the maximum dimension in the X-direction of the chip is not limited to that described above.

As shown in FIG. 3, the conductive plate 140 is electrically connected to the source electrode 133 of the chip 130 via a metal layer 160 and a bonding member 170. Specifically, the metal layer 160 that includes gold (Au) is located on the source electrode 133. The metal layer 160 and the conductive plate 140 are bonded by the bonding member 170 that is made from solder, a sintering material, etc. As described above, because the source electrode 133 includes aluminum (Al) as a major material, it is difficult to bond the conductive plate 140 directly to the source electrode 133 by solder, a sintering material, etc. Conversely, according to the embodiment, by covering the source electrode 133 with the metal layer 160 that includes gold (Au), the conductive plate 140 can be bonded to the source electrode 133 via the metal layer 160. However, the connection structure between the conductive plate and the source electrode is not limited to that described above.

As shown in FIG. 2, the chips 130 that are next to each other in the X-direction are connected in parallel. Hereinbelow, the chip 130 that is distant to the source connection leadframe 123 among the chips 130 next to each other in the X-direction is called a "first chip 130A". The chip 130 that is proximate to the source connection leadframe 123 among the chips 130 next to each other in the X-direction is called a "second chip 130B". In other words, the second chip 130B is the chip 130 that is positioned between the source connection leadframe 123 and the first chip 130A. The conductive plate 140 that is on the first chip 130A is called a "first conductive plate 140A"; and the conductive plate 140 that is on the second chip 130B is called a "second conductive plate 140B".

The gate electrodes 132 of the first and second chips 130A and 130B are electrically connected via the gate connection leadframe 122 and the wire 151 (a second wire). Specifically, one end portion of the wire 151 is bonded to the gate electrode 132 of the first chip 130A by wire bonding. The other end portion of the wire 151 is bonded to the gate connection leadframe 122 by wire bonding. The middle portion of the wire 151 is bonded to the gate electrode 132 of the second chip 130B by wire bonding. The bonding portions between the chips 130 and the wires 151 to 154 are shown as black filled circles for easier understanding of the description in FIG. 2.

The source electrodes 133 of the first and second chips 130A and 130B are electrically connected to the source connection leadframe 123 via two wires 152 (first wires). Specifically, one end portion of each wire 152 is bonded by wire bonding to the portion of the first conductive plate 140A protruding in the Y-direction from the first chip 130A. The other end portion of each wire 152 is bonded by wire bonding to the source connection leadframe 123. The middle portion of each wire 152 is bonded by wire bonding to the portion of the second conductive plate 140B protruding in the Y-direction from the second chip 130B.

One of the two wires 152 is connected to one Y-direction end portion of the first conductive plate 140A and one Y-direction end portion of the second conductive plate 140B. The other of the two wires 152 is connected to the other Y-direction end portion of the first conductive plate 140A and the other Y-direction end portion of the second conductive plate 140B.

The source electrodes 133 of the first and second chips 130A and 130B also are electrically connected to the source connection leadframe 123 via the two wires 153 (third wires). Specifically, one end portion of the wires 153 is bonded by wire bonding to the portion of the first conductive plate 140A positioned directly above the first chip 130A. The other end portion of each wire 153 is bonded by wire bonding to the source connection leadframe 123. The middle portion of each wire 153 is bonded by wire bonding to the portion of the second conductive plate 140B positioned directly above the second chip 130B.

The source electrode 133 of the second chip 130B is electrically connected to the source connection leadframe 123 via the two wires 154. Specifically, one end portion of each wire 154 is bonded by wire bonding to the portion of the second conductive plate 140B positioned directly above the second chip 130B. The other end portion of each wire 154 is bonded by wire bonding to the source connection leadframe 123.

The wire 151 is sandwiched between the two wires 154 in the Y-direction when viewed in top-view. The wires 151 and 154 are sandwiched between the two wires 153 in the Y-direction when viewed in top-view.

The positions in the X-direction of the bonding portions of the wires 152, 153, and 154 to the first chip 130A are different from each other. Similarly, the positions in the X-direction of the bonding portions of the wires 152, 153, and 154 to the second chip 130B are different from each other. However, the positions of the bonding portions of the wires 152, 153, and 154 to the first chip 130A may be the same; and the positions in the X-direction of the bonding portions of the wires 152, 153, and 154 to the second chip 130B may be the same. Although states in which the wire 153 and the wire 154 do not overlap when viewed in top-view are shown in FIGS. 1 and 2, the wire 153 and the wire 154 may partially overlap when viewed in top-view.

Thus, the chips 130 that are next to each other in the X-direction are connected in parallel by the multiple wires 152 and 153. The current amount that can be output by the semiconductor device 100 can be increased thereby. The number of wires used in the electrical connection between the source connection leadframe 123 and the chips 130 next to each other in the X-direction is not limited to 6. The wires may connect the source connection leadframe and three or more chips in parallel. Two or more wires may be bonded to the portion of each conductive plate that protrudes from the chip.

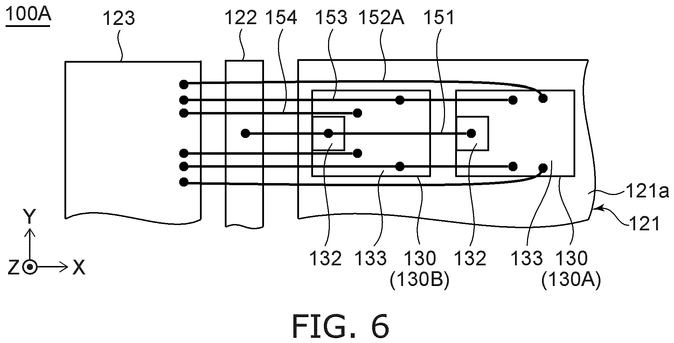

FIG. 6 is an enlarged top view showing a portion of a semiconductor device of a reference example. The semiconductor device 100A of the reference example differs from the semiconductor device 100 according to the embodiment in that the conductive plate 140 is not included. When the conductive plate 140 is not included, the number of wires that can be bonded to the source electrode 133 of the chip 130 is dependent on the surface area of the source electrode 133.

In particular, there are cases where the number of wires that can be bonded to the source electrode 133 of the second chip 130B is less than the number of wires that can be bonded to the source electrode 133 of the first chip 130A. Specifically, even when one end portion of a wire 152A can be bonded to the source electrode 133 of the first chip 130A on the same straight line extending in the X-direction as the wire 153, there are cases where there is no location to bond the middle portion of the wire 152A to the source electrode 133 of the second chip 130B because the wires 153 and 154 are bonded. In such a case, the wire 152A is bonded to the source electrode 133 of the first chip 130A and the source connection leadframe 123 and is not bonded to the source electrode 133 of the second chip 130B.

Therefore, in a configuration such as that of the semiconductor device 100A of the reference example, the length between the bonding portions of the wire 152A is greater than the length between the bonding portions of the wire 152 according to the embodiment. The deformation amount due to a temperature change increases as the length between the bonding portions of the wire 152A increases. As the deformation amount increases, the bonding portion breaks easily because the stress acting on the bonding portion of the wire 152A increases.

Conversely, in the semiconductor device 100 according to the embodiment as shown in FIG. 2, the conductive plate 140 is located on each chip 130. The middle portion of the wire 152 is bonded to the conductive plate 140 on the source electrode 133 of the chip 130 proximate to the source connection leadframe 123. Therefore, the increase of the length between the bonding portions of the wire 152 can be suppressed. The breakage of the bonding portion of the wire 152 can be suppressed thereby. As a result, a highly-reliable semiconductor device 100 can be provided.

Effects of the embodiment will now be described.

In the semiconductor device 100 according to the embodiment, the first conductive plate 140A is located on the first chip 130A; and the second conductive plate 140B is located on the second chip 130B. The maximum dimension L1 of the first conductive plate 140A in the second direction (the Y-direction) crossing the first direction (the X-direction) that is from the first chip 130A toward the second chip 130B is greater than the maximum dimension L2 in the Y-direction of the first chip 130A. Similarly, the maximum dimension L1 in the Y-direction of the second conductive plate 140B is greater than the maximum dimension L2 in the Y-direction of the second chip. The wire 152 is bonded to the source connection leadframe 123, the portion of the first conductive plate 140A protruding further in the Y-direction than the first chip 130A, and the portion of the second conductive plate 140B protruding further in the Y-direction than the second chip 130B. Therefore, the increase of the length of the wire 152 can be suppressed. The increase of the deformation amount due to the temperature change of the wire 152 can be suppressed thereby. As a result, the breakage of the bonding portion of the wire 152 due to the temperature change can be suppressed. Thus, a highly-reliable semiconductor device 100 can be provided.

The conductive plates 140 do not cover the gate electrodes 132 of the chips 130. Therefore, the gate electrode 132 of the first chip 130A and the gate electrode 132 of the second chip 130B can be electrically connected by the wire 151.

The semiconductor device 100 further includes a wire 153 that is bonded to the source connection leadframe 123, the portion of the first conductive plate 140A positioned directly above the first chip 130A, and the portion of the second conductive plate 140B positioned directly above the second chip 130B. Therefore, the current amount that can be output by the semiconductor device 100 can be increased.

The maximum dimension L3 in the X-direction of the first conductive plate 140A is less than the maximum dimension L4 in the X-direction of the first chip 130A; and the maximum dimension L3 in the X-direction of the second conductive plate 140B is less than the maximum dimension L4 in the X-direction of the second chip 130B. Therefore, the first conductive plate 140A and the second conductive plate 140B can be prevented from being proximate.

The source electrode 133 includes aluminum (Al); and the metal layer 160 that includes gold (Au) is located on the source electrode 133. Therefore, the source electrode 133 and the conductive plate 140 can be bonded by the bonding member 170 such as solder, a sintering material, etc.

An example is described in embodiments described above in which the wiring member is a leadframe. However, it is sufficient for the wiring member to be a member that is electrically connected to the first electrode of the first chip and the second electrode of the second chip and is included in the wiring of the semiconductor device. Accordingly, the wiring member may be, for example, a terminal or a wiring layer provided in a substrate.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions. Additionally, the embodiments described above can be combined mutually.

## Claims

1. A semiconductor device, comprising:
a first chip (130A) including a first electrode (133);
a wiring member (123) separated from the first chip (130A);
a second chip (130B) located between the first chip (130A) and the wiring member (123), the second chip (130B) including a second electrode (133);
a first conductive plate (140A) located on the first electrode (133) and electrically connected to the first electrode (133), a maximum dimension (L1) in a second direction (Y) of the first conductive plate (140A) being greater than a maximum dimension (L2) in the second direction (Y) of the first chip (130A), the second direction (Y) crossing a first direction (X), the first direction (X) being from the first chip (130A) toward the second chip (130B);
a second conductive plate (140B) located on the second electrode (133) and electrically connected to the second electrode (133), a maximum dimension (L1) in the second direction (Y) of the second conductive plate (140B) being greater than a maximum dimension (L2) in the second direction (Y) of the second chip (130B); and
a first wire (152),
the first wire (152) being bonded to the wiring member (123), a portion of the first conductive plate (140A) protruding further in the second direction (Y) than the first chip (130A), and a portion of the second conductive plate (140B) protruding further in the second direction (Y) than the second chip (130B).

2. The device according to claim 1, further comprising:
a second wire (151),
the first chip (130A) further including a third electrode (132) located at a surface at which the first electrode (133) is located,
the first conductive plate (140A) not covering the third electrode (132),
the second chip (130B) further including a fourth electrode (132) located at a surface at which the second electrode (133) is located,
the second conductive plate (140B) not covering the fourth electrode (132),
the second wire (151) being bonded to the third electrode (132), extending from the third electrode (132) toward the fourth electrode (132), and being bonded to the fourth electrode (132).

3. The device according to claim 2, wherein
the first chip (130A) and the second chip (130B) each are MOSFETs,
the first electrode (133) is a source electrode of the first chip (130A),
the third electrode (132) is a gate electrode of the first chip (130A),
the second electrode (133) is a source electrode of the second chip (130B), and
the fourth electrode (132) is a gate electrode of the second chip (130B).

4. The device according to any one of claims 1 to 3, further comprising:
a third wire (153),
the third wire (153) being bonded to the wiring member (123), a portion of the first conductive plate (140A) positioned directly above the first chip (130A), and a portion of the second conductive plate (140B) positioned directly above the second chip (130B).

5. The device according to any one of claims 1 to 4, wherein
a maximum dimension (L3) in the first direction (X) of the first conductive plate (140A) is less than a maximum dimension (L4) in the first direction (X) of the first chip (130A), and
a maximum dimension (L3) in the first direction (X) of the second conductive plate (140B) is less than a maximum dimension (L4) in the first direction (X) of the second chip (130B).

6. The device according to any one of claims 1 to 5, further comprising:
a first metal layer (160) located on the first electrode (133), the first metal layer (160) including gold;
a second metal layer (160) located on the second electrode (133), the second metal layer (160) including gold;
a first bonding member (170) positioned between the first metal layer (160) and the first conductive plate (140A), the first bonding member (170) being conductive and bonding the first metal layer (160) and the first conductive plate (140A); and
a second bonding member (170) positioned between the second metal layer (160) and the first conductive plate (140A), the second bonding member (170) being conductive and bonding the second metal layer (160) and the second conductive plate (140B),
the first electrode (133) and the second electrode (133) each including aluminum.
